# EUROPEAN PATENT SPECIFICATION

(11) **EP 1 688 706 B1**
(45) Date of publication and mention of the grant of the patent: **29.12.2010**
(21) Application number: 06001825.6
(22) Date of filing: 30.01.2006
(51) Int. Cl.: G01C 19/56, H01L 41/053

(54) **Piezoelectric device and electronic apparatus**
Piezoelektrische Vorrichtung und elektronisches Gerät
Dispositif piézoélectrique et appareil électronique

(30) Priority: 04.02.2005 JP 2005028688
(43) Date of publication of application: 09.08.2006
(73) Proprietor: Seiko Epson Corporation, Shinjuku-ku, Tokyo 163-0811 (JP)
(72) Inventor: Imamura, Minehiro, Suwa-shi Nagano-ken (JP); Mizuno, Shinji, Suwa-shi Nagano-ken (JP)
(74) Representative: HOFFMANN EITLE

(56) References cited:
- WO-A-00/55577
- JP-A- 11 211 481
- US-B1- 6 169 254
- US-B1- 6 195 261

## Description

### BACKGROUND

### 1. Technical Field

The present invention relates to a piezoelectric device and an electronic apparatus.

### 2. Related Art

Conventionally, piezoelectric devices are used in various types of electronic apparatuses such as acceleration detectors and angular velocity detectors, or digital videos, mobile communication apparatuses, and so on. One widely used type of piezoelectric device includes a piezoelectric module which consists of a piezoelectric element contained in a package and is packaged on a printed circuit board or the like.

Japanese Unexamined Patent Applications No. 2004-96403 and Japanese Unexamined Patent Applications No. H9-27725, disclose examples of techniques relating to a piezoelectric element which is contained in a package.

However, conventional techniques such as the above have the following problems.

In a digital television and a digital camera, two detection axes are set, and a third is set for angular detection. Since, in a conventional piezoelectric module, one piezoelectric element can only detect one detection axis, a plurality of piezoelectric elements must be provided.

However, current reductions in the size and thickness of piezoelectric devices make it difficult to ensure packaging space for a plurality of piezoelectric elements with different detection axis.

Furthermore, when installing a plurality of piezoelectric elements with different detection axis, the detection axis of each piezoelectric element must be precisely positioned, and the positional relationship between a plurality of the detection axes must also be set with high precision. This makes positioning exceptionally complicated.

### SUMMARY

An advantage of some aspects of the invention is to provide a piezoelectric device which enables a piezoelectric element to be positioned easily while keeping the device small and thin, and an electronic apparatus which includes this piezoelectric device.

A first aspect of the invention provides a piezoelectric device including: packages, each of which having therein a piezoelectric element having a predetermined direction of detection, wherein the packages are connected to each other so that the directions of detection of the piezoelectric elements intersect each other.

Since the piezoelectric device of this invention forms a module in which a plurality of piezoelectric elements having different axes (detection directions) are combined beforehand, increase in the size and thickness of the device can be suppressed more effectively than when the plurality of piezoelectric elements are mounted individually. In this invention, since the plurality of piezoelectric elements (detection directions) are combined in a single structure beforehand such that they intersect each other, it becomes possible to detect acceleration, angular velocity, and the like, along two or more axes. In addition, the positioning operation which must be performed when mounting the piezoelectric elements can be significantly simplified.

It is preferable that, in the piezoelectric device of the first aspect of the invention, further include a bent flexible substrate, the piezoelectric element of each of the packages is packaged on the bent flexible substrate.

In this configuration, even when the piezoelectric elements intersect each other at a right-angle, their terminals can be easily connected.

It is preferable that, in the piezoelectric device of the first aspect of the invention, further include a frame holding a plurality of the package in a single structure.

Since a plurality of the packages containing the piezoelectric element are firmly attached to and held by the frame, a plurality of the piezoelectric elements can be positioned such that their detection directions intersect each other.

It is preferable that, in the piezoelectric device of the first aspect of the invention, further include a resin material fixing the packages.

It is preferable that, in the piezoelectric device of the first aspect of the invention, further include an adhesive fixing the packages.

It is preferable that, in the piezoelectric device of the first aspect of the invention, a constituent material of the package be any one of: ceramic, glass, metal, or resin.

It is preferable that, in the piezoelectric device of the first aspect of the invention, the packages have connection terminals, a constituent material of a top face of the connection terminal be any one of: copper, gold, or brazing filler metal.

A second aspect of the invention provides an electronic apparatus including the piezoelectric device described above.

According to this configuration, it is possible to provide an electronic apparatus which can detect acceleration, angular velocity, and the like, along two or more axes, and which can be packaged and manufactured easily.

### BRIEF DESCRIPTION OF THE DRAWINGS

FIG. 1 is a cross-sectional view of a piezoelectric device according to a first embodiment.

FIG. 2 is a cross-sectional view of a piezoelectric package which a piezoelectric element is incorporated in.

FIG. 3 is a perspective view showing a portion of the piezoelectric device.

FIG. 4 is a cross-sectional view of a piezoelectric device according to a second embodiment.

FIG. 5 is a cross-sectional view of a piezoelectric device according to a third embodiment.

FIG. 6 is a perspective view of an example of an electronic apparatus.

FIG. 7 is a cross-sectional view of a piezoelectric device according to another embodiment.

### DESCRIPTION OF EXEMPLARY EMBODIMENTS

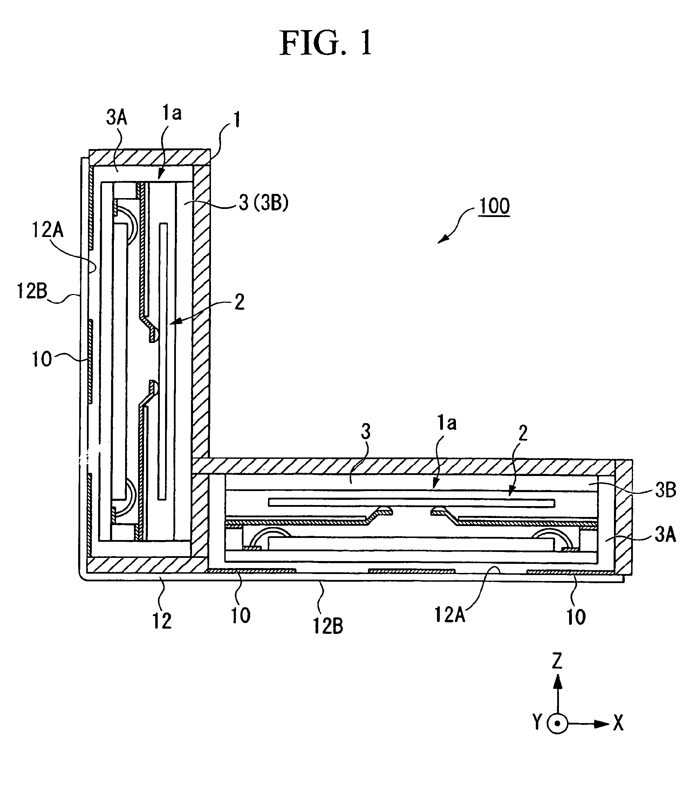

Exemplary embodiments of the piezoelectric device and the electronic apparatus according to this invention will be explained with reference to FIGS. 1 to 7. The piezoelectric device explained here has two axes (detection directions). These embodiments describe a piezoelectric device 100 which is applied in a gyro sensor for detecting angular velocity.

First Embodiment

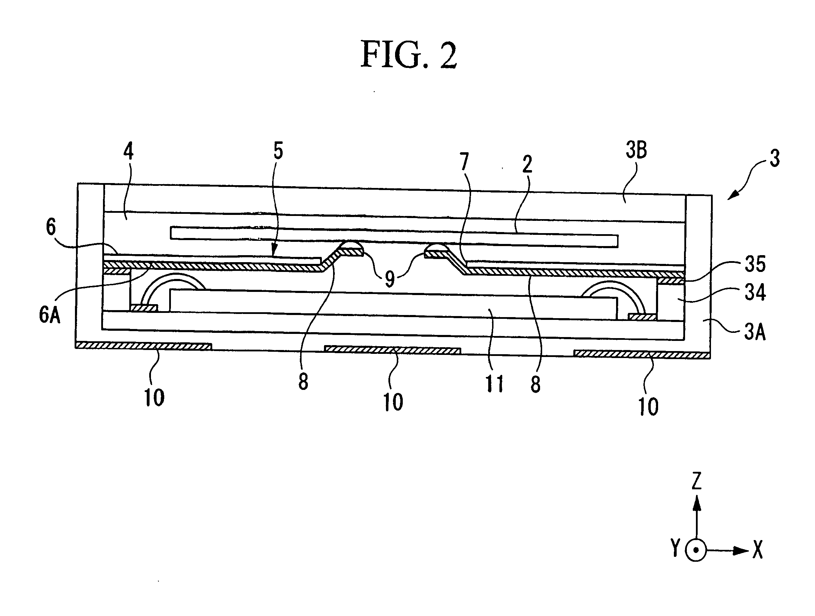

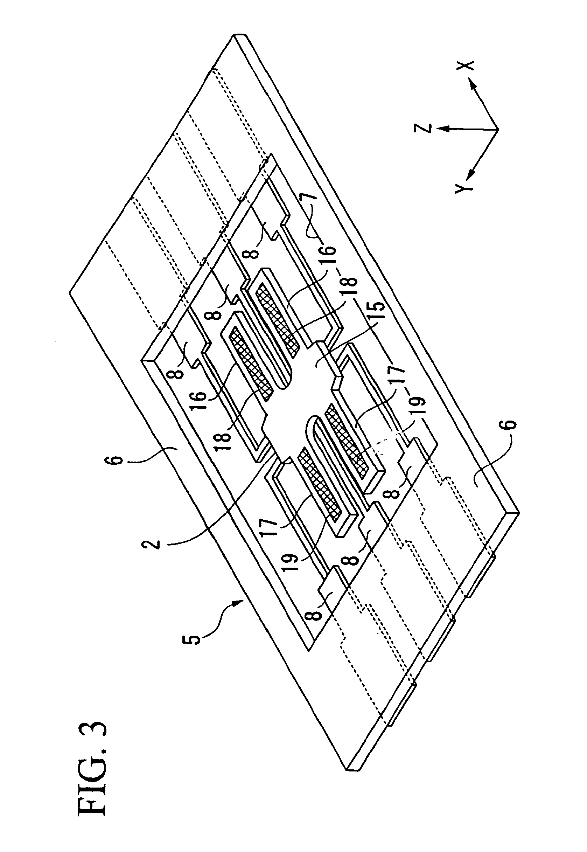

FIG. 1 is a cross-sectional view of the piezoelectric device 100 according to a first embodiment, FIG. 2 is a cross-sectional view of a piezoelectric package 3 (the package 3 extending in the left-to-right direction in the package of FIG. 1) which a piezoelectric element 2 is incorporated in, and FIG. 3 is a perspective view of an extracted part of the piezoelectric device 100.

As shown in FIG. 1, the piezoelectric device 100 includes a plurality of packages 3 (two packages in this example), each of which contains a piezoelectric element 2, and a frame 1 which holds a plurality of packages 3. In this embodiment, a tuning fork type piezoelectric vibrator is used as the piezoelectric element 2.

The frame 1 is made from a metal such as stainless steel, and is substantially L-shaped so as to form two storage spaces 1a extending in two directions (X direction and Z direction) which intersect each other at a substantial right-angle. The packages 3 are attached in respective storage spaces 1a and held by joining them to the frame 1 such that the detection directions of the piezoelectric elements 2 (explained later) intersect each other (at a substantial right-angle).

Each package 3 includes a box-like main section 3A which has an open top, and a cap section 3B which closes the open top of the main section 3A. An internal space 4 for containing the piezoelectric element 2 is provided inside each package 3. For example, ceramic, glass, metal, synthetic resin, or the like, or a compound of these, can be used as the material for forming the packages 3.

The piezoelectric element 2 is contained in the internal space 4 of the package 3. The piezoelectric element 2 is made from a piezoelectric material such as crystalline quartz. The piezoelectric element 2 is packaged in the package 3 via a TAB tape 5. The TAB tape 5 is also contained in the internal space 4 inside the package 3. The TAB tape 5 includes an insulating tape 6 of polyimide resin or the like, and conductive interconnection patterns 8 which are disposed on a bottom face 6A of the insulating tape 6. An opening 7 is provided in the center of the insulating tape 6. The overall shape of the insulating tape 6 is therefore ring-like, and so is the bottom face 6A. The interconnection patterns 8 extend from the edges of the insulating tape 6 toward its center, and their center-side ends are arranged in the opening 7. The center-side (opening 7 side) ends of the interconnection patterns 8 rise from the bottom face 6A side of the insulating tape 6 toward the top face side, and form packaging terminals 9 which are electrically connected to the piezoelectric element 2. The piezoelectric element 2 is electrically connected to the packaging terminals 9 of the interconnection patterns 8.

As shown in FIG. 3, a plurality of the interconnection patterns 8 are provided on the +X side and the -X side of the insulating tape 6 respectively (three on each side, a total of six, in this example) with the opening 7 in between. The interconnection patterns 8 extend toward the inner side of the opening 7, where a plurality of the packaging terminals 9 are provided in accordance with the number of interconnection patterns 8 (see FIG. 2).

As shown in FIG. 3, the piezoelectric element 2 includes a base 15, a pair of excitation vibrators 16 which extend to one side of the base 15 (the +X side), and a pair of detection vibrators 17 which extend to the other side of the base 15 (the -Y side). Excitation electrodes 18 for exciting the excitation vibrators 16 are provided for each thereof, and detection electrodes 19 for detecting an electromagnetic field generated by the detection vibrators 17 are provided for each thereof.

A control IC 11 is packaged in the package 3 on the bottom face 6A of the TAB tape 5. A wire bonding connects the control IC 11 to the main section 3A. Steps 34 are provided on both sides of the inside of the main section 3A, and connection terminals 35 are disposed on the steps 34. The piezoelectric element 2 is arranged in the main section 3A by placing the ends of the interconnection patterns 8 on the steps 34 and connecting them to the connection terminals 35 of the steps 34.

After the piezoelectric element 2 has been contained, the cap section 3B is attached to the open top of the main section 3A to achieve an airtight seal.

A plurality of electrodes 10 are provided on the rear face (the face on the -Z side) of the main section 3A for electrical connection to various types of apparatuses which incorporate the package 3. Top faces of these electrodes are formed from a material such as copper, metal, and brazing filler metal.

As shown in FIG. 1, the two packages 3 are held in the frame 1 with the electrodes 10 facing the outside of the L-shape (-Z side and -X side), and the electrodes 10 connect to interconnections (not shown) formed on one face 12A of a flexible substrate 12 which bends in an L-shape in accordance with the frame 1. Package interconnections (not shown) are formed on another face 12B of the flexible substrate 12, and are connected to the interconnections on the face 12A. These package interconnection connect to a circuit substrate and the like which the piezoelectric device 100 is packaged.

When a drive voltage is applied to the excitation electrodes 18 of the piezoelectric element 2, the excitation vibrators 16 vibrate in the Y-axis direction of FIG. 3 in what is termed tuning fork vibration. The vibration (tuning fork vibration) of the excitation vibrators 16 is transmitted to the detection vibrators 17, which vibrate in the Y-axis direction in conjunction with the vibration of the excitation vibrators 16. If the piezoelectric element 2 is rotated in the θX direction while the detection vibrators 17 are vibrating in the Y-axis direction, i.e. if an angular velocity ω acts in the θX direction, the Coriolis force acting in the direction of the vector sum of the vibration direction (Y-axis direction) and the angular velocity ω causes the detection vibrators 17 to vibrate in the X-axis direction. At this time, the detection vibrators 17 vibrate alternately in the +Z direction and the -Z direction (fork vibration).

The vibration or displacement of the detection vibrators 17 in the Z-axis direction generates an electromagnetic field inside them. This electromagnetic field generated in the detection vibrators 17 is detected by the detection electrodes 19. The detection electrodes 19 output detection signals outside the piezoelectric device 100 via the interconnection patterns 8 of the TAB tape 5, the connection terminals 35, and the electrodes 10. A processor (not shown) is provided outside the piezoelectric device 100, and determines the angular velocity ω based on the detection made by the detection electrodes 19.

To contain the piezoelectric element 2 in the main section 3A of the package 3, the control IC 11 is packaged in the main section 3A by die bonding. The piezoelectric element 2 is then contained in the main section 3A, and the interconnection patterns 8 of the TAB tape 5 are connected to the connection terminals 35 on the steps 34. The cap section 3B is attached to the opening in the main section 3A, and the air inside the main section 3A is vacuumed or substituted with an inert gas such as nitrogen via holes (not shown) which connect to the inside. The package 3 manufactured in this manner is attached via the electrodes 10 to the face 12A of the flexible substrate 12 prior to bending it. While bending the flexible substrate 12, each package 3 is firmly attached in the storage space 1a of the frame 1 and press-fitted therein, thereby completing the piezoelectric device 100.

One of the packages 3 (the package 3 provided along the XY plane at the bottom of FIG. 1) for example detects the angular velocity using the θX direction as the detection direction, and the other package 3 (the package 3 provided along the YZ plane on the left side of FIG. 1) for example detects the angular velocity using the θZ direction which intersects the θX direction as the detection direction.

The completed piezoelectric device 100 is packaged on a predetermined circuit substrate which attaches to the other face 12B of the flexible substrate 12.

As described above, according to the piezoelectric device 100 of this embodiment, since the two packages 3 having different detection directions are combined in a module, increase in the size and thickness can be suppressed more effectively than when each package is packaged individually. Furthermore, in this embodiment, since the packages 3 are combined such that the detection directions of the piezoelectric elements 2 intersect each other, i.e. such that there are two detection axes, the detection directions of the piezoelectric elements 2 and the relationship between their detection directions can be positioned beforehand, simplifying the positioning of the piezoelectric device 100. The manufacturing efficiency can also be improved, since the piezoelectric device 100 can be packaged on a circuit substrate or the like in a single operation.

In this embodiment, since a plurality of the packages 3 are combined simply by press-fitting them into the frame 1, the operation of combining them is simplified and the manufacturing efficiency is thereby increased. Moreover, in this embodiment, since two packages 3 are packaged on the bent flexible substrate 12, electrical interconnections between the packages 3 can be formed easily.

While in this embodiment, two packages 3 are packaged on the flexible substrate 12 and then held in the frame, this should not be regarded as limitative of the invention. It would be acceptable to connect the flexible substrate 12 to the packages 3 after they are press-fitted and held in the frame 1.

Second Embodiment

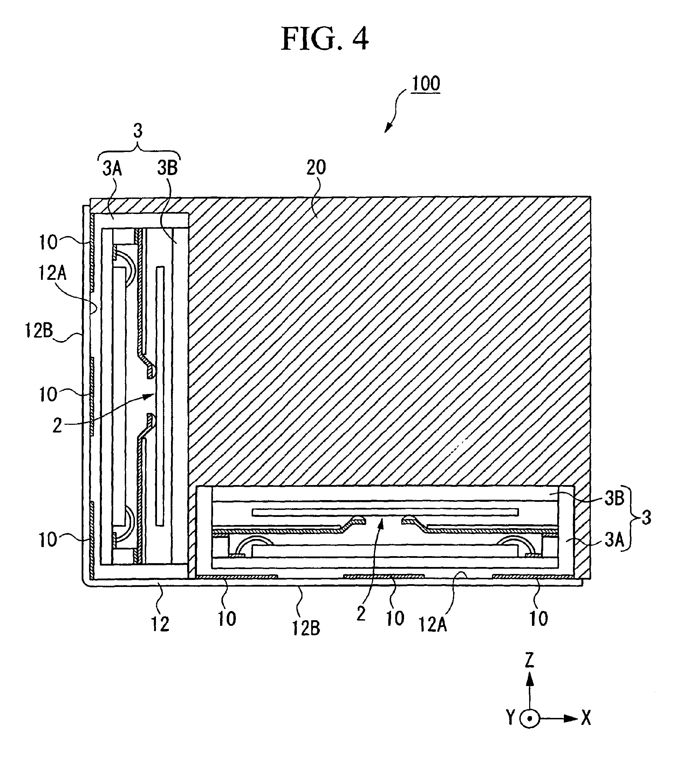

Subsequently, a second embodiment of the piezoelectric device 100 of this invention will be explained with reference to FIG. 4.

While in the first embodiment, two packages 3 are combined in the frame 1, in the second embodiment they are combined by filling with a mold material.

As shown in FIG. 4, two packages 3 are combined (molded together) such that the detection directions of the piezoelectric elements 2 intersect, by using a mold material (resin material) 20 formed from a non-conductive resin material such as epoxy resin.

In addition to obtaining the same effects and advantages as the first embodiment, this embodiment improves the operability (makes it easier to grasp) and simplifies the packaging operation, since the mold material 20 is filled between the packages 3.

Third Embodiment

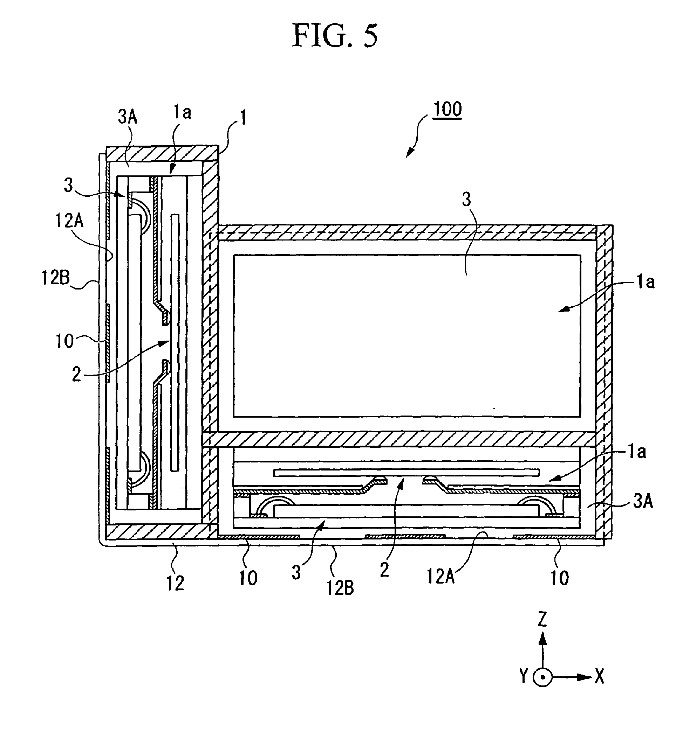

Subsequently, a third embodiment of the piezoelectric device 100 of this invention will be explained with reference to FIG. 5.

While in the first and second embodiments, the piezoelectric elements 2 are used to detect two axes, in this embodiment the frame 1 of the first embodiment is used to detect three axes.

As shown in FIG. 5, the frame 1 of this embodiment includes storage spaces 1a for storing packages 3 in the XZ plane, and three packages 3 with mutually intersecting detection directions are press-fitted into the frame 1. In this configuration, the flexible substrates 12 extend from points where they connect to the packages 3 in the XY plane (indicated by dotted lines in FIG. 5).

In this embodiment, increase in the size and thickness of the device can be suppressed more effectively than when each package is packaged individually. In addition, even when detection directions are set along three axes, the detection directions of the piezoelectric elements 2 and the relationship between their detection directions can be positioned beforehand, simplifying the positioning of the piezoelectric device 100.

Electronic Apparatus

The piezoelectric device 100 described above can be incorporated as a gyro sensor in, for example, a digital camera, a GPS, a PDA, or a mobile telephone.

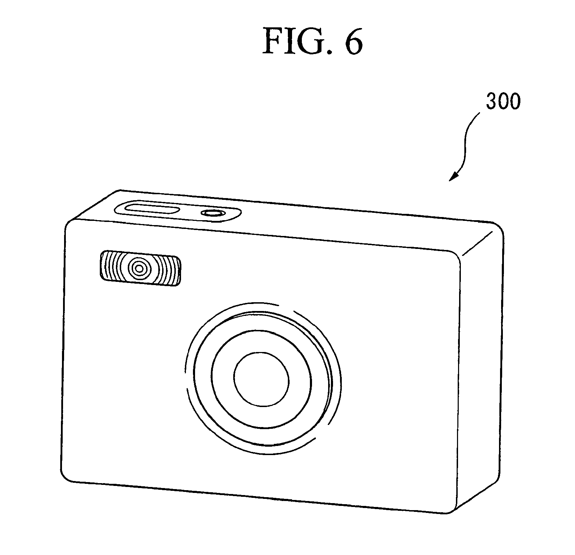

FIG. 6 is one example of an electronic apparatus which includes a gyro sensor including the piezoelectric device 100, being a perspective view of the schematic configuration of a digital still camera. As shown in FIG. 6, the piezoelectric device 100 is installed inside a casing of a digital still camera (electronic apparatus) 300.

According to the electronic apparatus incorporating the piezoelectric device 100, the apparatus can be made smaller and thinner and productivity can be improved.

While preferred embodiments of the invention have been described and illustrated above, it should be understood that these are exemplary of the invention and are not to be considered as limiting. Additions, omissions, substitutions, and other modifications can be made without departing from the spirit or scope of this invention. Accordingly, the invention is not to be considered as being limited by the foregoing description, and is only limited by the scope of the appended claims.

For example, when packaging the piezoelectric element 2 in the package main section 3A, the interconnection patterns 8 may be connected to the connection terminals 35 by an Ag paste of the epoxy-type or silicon type; alternatively, the interconnection patterns 8 may be bonded by single-point bonding or gang bonding using hot pressing or ultrasonic vibration.

The method for packaging the control IC 11 is not limited to wire bonding. Flip-chip packaging may be used instead.

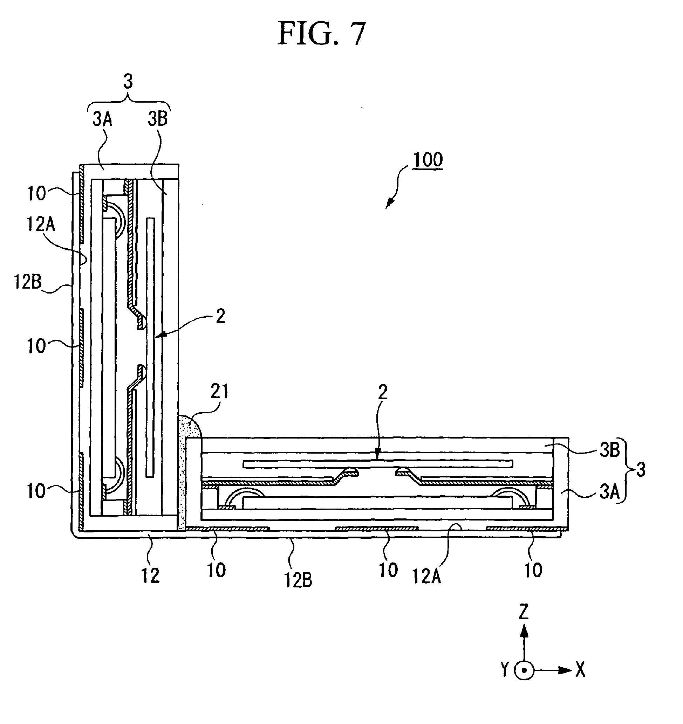

While in the above embodiments, a plurality of packages 3 are combined using the frame 1 and the module material 20, other configurations are acceptable. As for example shown in FIG. 7, the connection faces of two packages 3 including piezoelectric elements 2 whose detection directions intersect may be fixed together by an adhesive 21.

This configuration obtains the same effects and advantages as the previous embodiments.

## Claims

1. A piezoelectric device comprising:
packages (3), each of which having therein a piezoelectric element (2) having a predetermined direction of detection, the packages (3) being connected to each other so that the directions of detection of the piezoelectric elements (2) intersect each other, **characterized in that** the piezoelectric device comprises
a bent flexible substrate (12) on which each of the packages (3) is packaged, wherein
the packages (3) are held by a frame (1) in a single structure, or fixed by a resin material (20) or by an adhesive (21).

2. The piezoelectric device according to claim 1, wherein a constituent material of the package (3) is any one of:
ceramic, glass, metal or resin.

3. The piezoelectric device according to claim 1, wherein the packages (3) have connection terminals (35), a constituent material of a top face of the connection terminal (35) is any one of: copper, gold, or brazing filler metal.

4. An electronic apparatus comprising:
the piezoelectric device (100) according to claim 1.

## Patentansprüche

1. Piezoelektrische Einrichtung, umfassend:
Gehäuse (3), die darin jeweils ein piezoelektrisches Element (2) mit einer vorgegebenen Erfassungsrichtung aufweisen, wobei die Gehäuse (3) so miteinander verbunden sind, dass die Erfassungsrichtungen der piezoelektrischen Elemente (2) einander schneiden, **dadurch gekennzeichnet, dass** die piezoelektrische Einrichtung umfasst:
ein gekrümmtes, biegsames Substrat (12), an dem jedes der Gehäuse (3) gepackt ist, wobei
die Gehäuse (3) durch einen Rahmen (1) in einer einzelnen Struktur gehalten oder durch ein Harzmaterial (20) oder ein Haftmittel (21) befestigt sind.

2. Piezoelektrische Einrichtung nach Anspruch 1, bei der ein Bestandteilsmaterial des Gehäuses (3) eines der folgenden ist: Keramik, Glas, Metall oder Harz.

3. Piezoelektrische Einrichtung nach Anspruch 1, bei der die Gehäuse (3) Verbindungsanschlüsse (35) aufweisen, wobei ein Bestandteilsmaterial einer oberen Fläche des Verbindungsanschlusses (35) eines der folgenden ist: Kupfer, Gold oder Hartlötmetall.

4. Elektronische Vorrichtung, umfassend:
die piezoelektrische Einrichtung (100) nach Anspruch 1.

## Revendications

1. Dispositif piézoélectrique comprenant :
des boîtiers (3), chacun d'eux ayant en son sein un élément piézoélectrique (2) ayant une direction de détection prédéterminée, les boîtiers (3) étant reliés les uns aux autres de sorte que les directions de détection des éléments piézoélectriques (2) se croisent, **caractérisé en ce que** le dispositif piézoélectrique comprend
un substrat souple plié (12) sur lequel chacun des boîtiers (3) est agencé, dans lequel
les boîtiers (3) sont maintenus par un châssis (1) dans une seule structure, ou fixés par une matière de résine (20) ou par un adhésif (21).

2. Dispositif piézoélectrique selon la revendication 1, dans lequel une matière constitutive du boîtier (3) est l'une quelconque de : céramique, verre, métal ou résine.

3. Dispositif piézoélectrique selon la revendication 1, dans lequel les boîtiers (3) ont des bornes de connexion (35), une matière constitutive d'une face supérieure de la borne de connexion (35) est l'une quelconque de : cuivre, or, ou métal d'agent de remplissage de brasage.

4. Appareil électronique comprenant :
le dispositif piézoélectrique (100) selon la revendication 1.
